# EUROPÄISCHE PATENTANMELDUNG

(11) **EP 4 549 926 A1**
(43) Veröffentlichungstag der Anmeldung: **07.05.2025**
(21) Anmeldenummer: 23207307.2
(22) Anmeldetag: 01.11.2023
(51) Int. Cl.: G01N 27/87, G01R 33/00, G01N 24/00, G01R 33/26

(54) **SYSTEM UND VERFAHREN ZUM ORTSAUFGELÖSTEN MESSEN DER MAGNETISCHEN FLUSSDICHTE EINES MAGNETISCHEN STREUFELDS AN DER OBERFLÄCHE EINES PRÜFLINGS**

(71) Anmelder: Fraunhofer-Gesellschaft zur Förderung der angewandten Forschung e.V., 80686 München (DE)
(72) Erfinder: BLUG, Andreas, 79110 Freiburg (DE); THIEMANN, Kerstin, 79110 Freiburg (DE); LASKIN, Gennadii, 79110 Freiburg (DE); KOSS, Peter, 79110 Freiburg (DE)
(74) Vertreter: WSL Patentanwälte Partnerschaft mbB

(57) **Zusammenfassung**

System und ein Verfahren zum ortsaufgelösten Messen der magnetischen Flussdichte eines magnetischen Streufelds an der Oberfläche eines Prüflings, bevorzugterweise mit einem optischen gepumpten Magnetometer (OPM) oder einem SQUID. Es ist die zu Grunde liegende Idee, eine mechanische Eigenschaft des Prüflings ortsaufgelöst anhand des magnetischen Streufelds an der Oberfläche des Prüflings zu erfassen. Das magnetische Streufeld an der Oberfläche bildet dann ein Maß für eine mechanische Spannungskonzentration in dem Prüfling.

## Beschreibung

Die vorliegende Erfindung betrifft ein System und ein Verfahren zum ortsaufgelösten Messen der magnetischen Flussdichte eines magnetischen Streufelds an der Oberfläche eines Prüflings.

Bei jeder Umformung eines Werkstücks, einschließlich der Urformung des Werkstücks, werden zwangsläufig lokale Spannungskonzentrationen in das Werkstück eingebracht. Anschauliche Beispiele dafür sind ein Umformen, beispielsweise durch spanende Bearbeitung, oder ein Fügen des Werkstücks, beispielsweise durch Schweißen. Wird das fertige Bauteil während seiner Verwendung belastet, so sorgen die Spannungskonzentrationen dafür, dass lokal bruchmechanische Schwellenwerte für die Ausbildung von Anrissen, wie zum Beispiel die Fließ- oder Spaltbruchgrenze, erreicht und gegebenenfalls überschritten werden. Die lokale Spannung im Bauteil überlagert sich dabei mit der thermischen oder mechanischen Spannung aufgrund der Verwendung des Bauteils. Daher führen die lokalen Spannungskonzentrationen aufgrund der Umformung im Laufe der späteren, typischerweise zyklischen Beanspruchung des Bauteils bei seinem Gebrauch zur Ausbildung von Anrissen und somit irgendwann zum Versagen des Bauteils.

Wünschenswert ist es daher, lokale Bereiche eines Werkstücks mit Spannungskonzentrationen oder (Vor-)Schädigungen frühzeitig zu erfassen und entweder ein Werkstück gar nicht erst als Bauteil auszuliefern oder das Bauteil vor seinem Versagen zu wechseln.

Daher ist es Aufgabe der vorliegenden Erfindung, ein System und ein Verfahren bereitzustellen, die es ermöglichen, eine mechanische Spannungskonzentration in einem Prüfling zu erfassen, bevor der Prüfling versagt.

Die erfindungsgemäße Aufgabe wird durch ein System zum ortsaufgelösten Messen der magnetischen Flussdichte eines magnetischen Streufelds an der Oberfläche eines Prüflings in dem Prüfling gemäß dem unabhängigen Anspruch 1 gelöst. Dazu weist das erfindungsgemäße System ein Prüfmagnetometer auf, wobei das Prüfmagnetometer eine Nachweisgrenze von 30 nT oder weniger aufweist und wobei das Prüfmagnetometer in einem Betrieb des Systems ein von einem Prüfmagnetfeld abhängiges Prüfsignal ausgibt. Ein Prüfmagnetometer mit einer Nachweisgrenze von 30 nT oder weniger ist in der Lage, eine Änderung eines Magnetfelds zu messen, das größer ist als die Nachweisgrenze. Die Nachweisgrenze des Prüfmagnetometers kann auch als Untergrenze des Messintervalls des Prüfmagnetometers bezeichnet werden.

In einer Ausführungsform beträgt die Nachweisgrenze 0,3 nT oder weniger und bevorzugt 0,03 nT oder weniger.

Erfindungsgemäß ist das Prüfmagnetometer innerhalb einer passiven magnetischen Abschirmung sowie innerhalb einer aktiven magnetischen Abschirmung angeordnet. Dabei umfasst die aktive magnetische Abschirmung ein Abschirmmagnetometer, eine Abschirmspule und eine Abschirmsteuerung. Das Abschirmmagnetometer ist derart wirksam mit der Abschirmsteuerung verbunden, dass die Abschirmsteuerung in dem Betrieb des Systems ein Abschirmmesssignal von dem Abschirmmagnetometer empfängt und die Abschirmsteuerung derart wirksam mit der Abschirmspule verbunden ist, dass die Abschirmspule in dem Betrieb des Systems ein Abschirmsteuersignal von der Abschirmsteuerung empfängt. Die Abschirmsteuerung ist ferner derart eingerichtet, dass sie in dem Betrieb des Systems aus dem Abschirmmesssignal das Abschirmsteuersignal derart bestimmt und an die Abschirmspule ausgibt, dass die mit dem Abschirmsteuersignal erregte Abschirmspule ein von dem Abschirmmagnetometer erfasstes magnetisches Feld kompensiert.

Das System weist weiterhin entweder einen Flussleiter mit einer Prüffläche oder eine Induktionskombination, die eine Pick-up-Spule mit einer Prüffläche und eine Erregerspule umfasst, auf. Weist das System einen Flussleiter auf, so ist der Flussleiter derart ausgestaltet und angeordnet, dass in dem Betrieb des Systems der Flussleiter einen magnetischen Fluss eines magnetischen Streufelds von der Oberfläche des Prüflings, das die Prüffläche durchsetzt, durch die aktive magnetische Abschirmung und durch die passive magnetische Abschirmung zu dem Prüfmagnetometer leitet, sodass das von dem Streufeld abhängige Prüfmagnetfeld das Prüfmagnetometer durchsetzt. Umfasst das System hingegen eine Induktionskombination, so ist diese derart ausgestaltet und angeordnet, dass der magnetische Fluss des magnetischen Streufelds von der Oberfläche des Prüflings die Prüffläche durchsetzt und ein so generierter elektrischer Strom über die Erregerspule in dem Prüfmagnetometer ein zu dem Streufeld proportionales Prüfmagnetfeld erzeugt. Der Flussleiter oder die Induktionskombination ist derart ausgestaltet, dass sie eine zu der Oberfläche des Prüflings senkrechte Komponente der magnetischen Flussdichte des Streufelds erfasst.

Erfindungsgemäß sind das Prüfmagnetometer, die passive magnetische Abschirmung, die aktive magnetische Abschirmung sowie der Flussleiter oder die Induktionskombination in einem Messkopf zusammengefasst. Dabei ist der Messkopf gegenüber der Oberfläche des Prüflings bewegbar. Ein Aktor ist derart ausgestaltet und angeordnet, dass er in dem Betrieb des Systems den Messkopf automatisiert bewegt, um eine Mehrzahl von Objektpunkten auf der Oberfläche des Prüflings ortsaufgelöst zu rastern. Eine Auswertungs- und Steuereinrichtung übernimmt die Datenverarbeitung der Prüfsignale sowie die Steuerung des Systems. Dazu ist die Auswertungs- und Steuereinrichtung derart wirksam mit dem Aktor verbunden, dass der Aktor in dem Betrieb des Systems ein Aktorsteuersignal von der Auswertungs- und Steuereinrichtung empfängt. Ferner ist die Auswertungs- und Steuereinrichtung derart wirksam mit dem Prüfmagnetometer verbunden, dass die Auswertungs- und Steuereinrichtung in dem Betrieb des Systems das Prüfsignal von dem Prüfmagnetometer empfängt. Die Auswertungs- und Steuereinrichtung zeichnet in dem Betrieb des Systems jeweils ein Prüfsignal für jeden Objektpunkt auf.

In einer Ausführungsform der Erfindung erzeugt die Auswertungs- und Steuereinrichtung ein Bild mit einem Bildpunkt für jeden Objektpunkt, wobei für jeden Bildpunkt ein von dem Prüfsignal abhängiger Wert dargestellt ist.

Es ist die der Erfindung zu Grunde liegende Idee, ein System und ein Verfahren bereitzustellen, die es ermöglichen, eine mechanische Eigenschaft des Prüflings ortsaufgelöst anhand des magnetischen Streufelds an der Oberfläche des Prüflings zu erfassen. Das magnetische Streufeld an der Oberfläche bildet dann ein Maß für eine mechanische Spannungskonzentration in dem Prüfling.

In vielen Werkstoffen, insbesondere in ferro- und ferrimagnetischen Werkstoffen, gehen lokale mechanische Spannungskonzentrationen, lokale Gefügeveränderungen oder lokale Schädigungen des Werkstoffs mit magnetischen Momenten einher und verändern daher lokal das magnetische Streufeld an der Oberfläche des Prüflings. Diese lokalen Veränderungen des magnetischen Streufelds sind allerdings sehr klein.

Mittlerweile sind Magnetometer verfügbar, die sich als Prüfmagnetometer für die vorliegende Erfindung eignen. Diese haben die erforderliche Nachweisgrenze und ermöglichen es, eine Änderung des magnetischen Streufelds an der Oberfläche des Prüflings von 50 pT oder weniger zu messen.

In einer Ausführungsform der Erfindung ist das Prüfmagnetometer ein Quantenmagnetometer, insbesondere ein supraleitendes Quanteninterferometer oder ein optisch gepumptes Magnetometer.

Ein Beispiel für ein geeignetes Magnetometer ist ein supraleitendes Quanteninterferometer (SQUID; englisch: superconducting quantum interference device), wobei aufgrund der erforderlichen tiefen Temperaturen das Magnetfeld mit Pick-up-Spulen innerhalb des Probenraums aufgenommen und aus dem Probenraum und damit aus dem Abschirmgehäuse hinaus geleitet werden muss, da die supraleitenden Teile des SQUID nur bei tiefen Temperaturen mit dem erforderlichen raumfüllenden apparativen Aufwand betrieben werden können.

In einer Ausführungsform der Erfindung ist daher das Magnetometer ein bei Raumtemperatur betreibbares Magnetometer. Ein geeignetes Magnetometer ist ein optisch gepumptes Magnetometer (OPM; englisch: optically pumped magnetometer), insbesondere ein optisch gepumptes Nullfeld-Magnetometer. In einem optisch gepumpten Magnetometer werden gasförmige Atome als Magnetfeldsonden eingesetzt. Zu diesem Zweck wird der quantenmechanische Zustand der Atome mit Laserlicht präpariert ("gepumpt") und die Wirkung des zu messenden Magnetfelds auf diesen Zustand der verwendeten Atome wird mit Laserlicht ausgelesen. Bei der Präparation werden die Spins, der in einer Dampfzelle befindlichen Atome zu einer kohärenten Rotation angeregt. In dem zu messenden Magnetfeld präzedieren die Spins dann kollektiv mit der Lamorfrequenz, welche proportional zur magnetischen Flussdichte ist. Diese Wirkung auf den quantenmechanischen Spinzustand der Atome wird dann mittels laserspektroskopischer Methoden ausgelesen. Die Empfindlichkeit von OPMs ist ähnlich der von SQUIDs. Als sensitives Medium in einem OPM dienen gasförmige Atome, beispielsweise Helium 4 (⁴He) sowie verdampfte Alkalimetalle wie Kalium, Rubidium oder Cäsium. Daher sind keine tiefen, kyrogenen Temperaturen für den Betrieb erforderlich. OPMs sind mit kleinen Abmessungen realisierbar und sie sind daher vollständig in dem von dem Abschirmgehäuse definierten Probenraum unterzubringen. Eine Gaszelle, in der sich die verwendeten Atome befinden, bildet den für das zu messende Prüfmagnetfeld sensitiven Bereich des OPM.

Ist das Prüfmagnetometer ein OPM, so ist eine dem Magnetometer zugewandte Endfläche des Flussleiters oder zumindest eine Fläche der Erregerspule derart angeordnet, dass das von dieser Fläche ausgehende magnetische Feld den sensitiven Bereich durchsetzt.

Ähnlich hohe Sensitivitäten wie mit einem OPM können auch mit anderen bei Raumtemperatur zu betreibenden Magnetometern, so wie sie beispielsweise von der Firma TDK unter der Marke Nivio kommerziell erhältlich sind, bereitgestellt werden.

Allerdings kann auch ein solches Prüfmagnetometer mit einer Nachweisgrenze von 30 nT oder weniger in einer industriellen Umgebung nicht ohne weitere Maßnahmen genutzt werden, um Änderungen im magnetischen Streufeld an der Oberfläche des Prüflings zu erfassen.

In einer Ausführungsform der Erfindung umfasst das System eine Mehrzahl von Magnetometern, von denen jedes einem Flussleiter oder einer Induktionskombination zugeordnet ist.

Selbst ein Magnetometer mit einer Nachweisgrenze von 30 nT oder weniger kann nicht genauer messen als die elektromagnetischen Störungen der Umgebung, welche typischerweise in der Größenordnung des Erdmagnetfelds von 40 µT liegen. Darüber hinaus sind diese Störungen in einer industriellen Umgebung oft sogar größer als der Dynamikumfang des Prüfmagnetometers, sodass die Änderungen des magnetischen Streufelds an der Oberfläche des Prüflings unabhängig von äußeren Störungen gar nicht messfähig sind.

In einer Ausführungsform der Erfindung hat das Prüfmagnetometer eine Nachweisgrenze von 1 nT oder weniger.

Daher wird erfindungsgemäß das Prüfmagnetometer in einer zweifachen Abschirmung aus einer passiven magnetischen Abschirmung und einer aktiven magnetischen Abschirmung vor äußeren Störungen abgeschirmt. In einer Ausführungsform der Erfindung weist die Kombination aus der passiven und der aktiven magnetischen Abschirmung für magnetische Felder mit Modulationsfrequenzen in einem Bereich von 0 Hz bis 100 Hz einen Schirmfaktor von 10.000 oder mehr auf.

Die passive magnetische Abschirmung besteht in einer Ausführungsform der Erfindung aus einem Metall mit hoher magnetischer Permeabilität, beispielsweise mit einer weichmagnetischen Nickel-Eisen-Legierung mit 72 bis 80 % Nickel sowie Anteilen von Kupfer, Molybdän, Cobalt oder Chrom, d.h. einem Mu-Metall. Dabei umgibt die passive magnetische Abschirmung das Prüfmagnetometer und weist so wenige Durchbrechungen des so gebildeten Gehäuses auf wie möglich. In einer Ausführungsform der Erfindung weist die passive magnetische Abschirmung für magnetische Felder mit Modulationsfrequenzen in einem Bereich von 0 Hz bis 500 Hz einen Schirmfaktor von 100 oder mehr auf. Die passive magnetische Abschirmung reduziert das bei terrestrischen Messungen immer vorhandene Magnetfeld der Erde auf den Dynamikbereich des Magnetometers.

Das Hindurchführen des magnetischen Flusses durch die Abschirmung mit Hilfe eines Flussleiters oder der Induktionskombination ermöglicht es, auch größere Proben ortsaufgelöst zu vermessen, die sich nicht innerhalb der Abschirmung anordnen lassen.

Die erforderlichen Schirmfaktoren sind mit ausschließlich passiven Abschirmungen allein aber nicht erreichbar. Daher ist erfindungsgemäß zusätzlich eine aktive Abschirmung vorgesehen. Für die Realisierung der aktiven magnetischen Abschirmung gibt es eine Reihe von möglichen Ausführungsformen. Dabei umfasst die aktive magnetische Abschirmung immer mindestens ein Abschirmmagnetometer und mindestens eine Abschirmspule.

In einer Ausführungsform der Erfindung umfasst die aktive magnetische Abschirmung mindestens drei Paare mit jeweils einem Abschirmmagnetometer und einer Abschirmspule. Jeweils ein Paar ist auf einer Fläche eines Polyeders angeordnet, wobei die Abschirmsteuerung derart eingerichtet ist, dass sie in dem Betrieb des Systems aus den Abschirmsignalen Abschirmsteuersignale derart bestimmt und an die Abschirmspulen ausgibt (d.h. diese damit treibt), dass die mit dem Abschirmsteuersignal erregte Abschirmspule ein von dem Abschirmmagnetometer erfasstes magnetisches Feld, welches die jeweilige Oberfläche des Polyeders durchsetzt, kompensiert.

In einer Ausführungsform ist der Polyeder ein Quader oder ein Würfel, wobei auf jeder der Seitenflächen des Quaders oder des Würfels ein Paar aus einem Abschirmmagnetometer und einer Abschirmspule vorgesehen ist. Die Paare sind dann voneinander linear unabhängig. Jedes Paar aus einem Magnetometer und einer Spule regelt in einer Ausführungsform den magnetischen Fluss durch die Fläche der Spule auf einen Minimalwert, d.h. auf einen möglichst geringen Wert, vorzugsweise auf null oder auf etwa null. Durch die Kombination aller sechs Seiten kann somit das Magnetfeld innerhalb des Würfels insgesamt auf einen Minimalwert, d.h. auf einen möglichst geringen Wert, vorzugsweise auf null oder auf etwa null. geregelt werden. In einer Ausführungsform ist der Minimalwert des durch die aktive Abschirmung hindurchtretenden verbleibenden (Stör-)Magnetfelds kleiner als ein Wert, der gegeben ist aus der Summe der Nachweisgrenze des Prüfmagnetometers und dem dynamischen Bereich des Prüfmagnetometers, vorzugsweise kleiner als dreiviertel (3/4) dieses Werts und besonders bevorzugt kleiner als die Nachweisgrenze des Prüfmagnetometers.

In einer Ausführungsform der Erfindung ist das Abschirmmagnetometer ein herkömmliches Vektormagnetometer, z.B. ein Fluxgate. Das Abschirmmagnetometer misst die Komponenten des Restfeldes innerhalb der Abschirmung. Aus diesen Messwerten des Restfeldes innerhalb der Abschirmung werden Ströme zum Erregen der Abschirmspulen berechnet, die jeweils mindestens eine Komponente des Restfeldes beeinflussen.

Es sind verschiedene Anordnungen der passiven magnetischen Abschirmung und der aktiven magnetischen Abschirmung zueinander möglich. In einer Ausführungsform der Erfindung sind die Abschirmspulen außerhalb der passiven magnetischen Abschirmung angeordnet. In einer alternativen Ausführungsform sind die Abschirmspulen innerhalb der passiven magnetischen Abschirmung angeordnet. Es sind jedoch auch Ausführungsformen denkbar, in denen die Abschirmspule zwischen zwei Lagen der passiven magnetischen Abschirmung angeordnet ist.

Dabei kann die Abschirmsteuerung innerhalb oder außerhalb der Abschirmung angeordnet sein.

Ein magnetischer Flussleiter greift an der Oberfläche des Prüflings die zu messende zu der Oberfläche senkrechte Komponente des magnetischen Felds ab und leitet diese an das Magnetometer weiter. Weist das Material des magnetischen Flussleiters eine hohe magnetische Permeabilität auf und ist die Prüffläche parallel zu dem Abschnitt der Oberfläche des Prüflings, den es zu vermessen gilt, so greift der Flussleiter aufgrund der magnetischen Brechung die Feldkomponente senkrecht zu der Oberfläche des Prüflings ab.

In einer Ausführungsform der Erfindung ist die Prüffläche eine ebene Fläche. Dabei ist die Prüffläche in einer Ausführungsform derart angeordnet, dass sie parallel zu der zu vermessenden Oberfläche des Prüflings ausrichtbar oder ausgerichtet ist.

In einer Ausführungsform besteht der magnetische Flussleiter aus einem weichmagnetischen Material, z.B. einem Ni-Zn-Ferrit oder einem Mn-Zn-Ferrit.

Umfasst das System eine Induktionskombination, so wird in der Pick-up-Spule durch die Bewegung des Messkopfes relativ zu der Oberfläche des Prüflings und bei einer Änderung der magnetischen Feldstärke an der Oberfläche ein Strom induziert, welche über elektrische Leiter an die Erregerspule am Magnetometer übertragen wird.

In einer Ausführungsform ist zumindest die Pick-up-Spule oder die Erregerspule als mehrlagige Platine ausgeführt, sodass sie mechanisch stabil sind.

In einer Ausführungsform umfasst die Induktionskombination zwei Erregerspulen, die nach Art eines Helmholzspulenpaars um den sensitiven Bereich des Prüfmagnetometers angeordnet sind, sodass ein möglichst homogenes magnetisches Feld den sensitiven Bereich des Prüfmagnetometers durchsetzt.

Das Prüfmagnetometer, die passive magnetische Abschirmung, die aktive magnetische Abschirmung sowie der Flussleiter oder die Induktionskombination sind in einem Messkopf integriert, der gegenüber dem Prüfling bewegbar ist, um eine Vielzahl von Objektpunkten ortausgelöst erfassen zu können.

Der Aktor, welcher den Messkopf bewegt, ist einer Ausführungsform derart ausgestaltet, dass er möglichst geringe magnetische Streufelder generiert. In einer Ausführungsform ist der Aktor nicht elektrisch angetrieben. Insbesondere umfasst der Aktor in einer Ausführungsform keine Elektromotoren mit Spulen oder Permanentmagneten. In einer Ausführungsform umfasst der Aktor einen Piezomotor oder einen mit Druckluft oder einer Flüssigkeit betriebenen Antrieb. Auch ein Aktor mit einem Riemen- oder Spindelantrieb, wobei der antreibende Motor weit entfernt von dem Messkopf positioniert ist, ist denkbar.

Lokale Spannungskonzentrationen im Prüfling können bei längerfristiger (zyklischer) Belastung zur Ausbildung von Anrissen führen. Wenn eine Vergleichsspannung erreicht ist, gewinnt einer der vielen Anrisse gegenüber den anderen Anrissen und sein Risswachstum geht vom Stadium I (Mikroriss) in das Stadium II (Risswachstum) über. Dieser Übergang vom Stadium I in das Stadium II erfolgt typischerweise bei einer Risslänge in einem Bereich von 0,05 mm bis 2 mm. Daher gilt es in einer Ausführungsform das System derart auszugestalten, dass es die Messung der magnetischen Flussdichte des magnetischen Streufelds an der Oberfläche des Prüflings mit einer Ortsauflösung von 2 mm oder weniger ermöglicht.

In einer Ausführungsform der Erfindung ist die Prüffläche eine Kreisfläche mit einem Durchmesser in dem Bereich von 0,05 mm bis 5 mm, bevorzugt in einem Bereich von 0,1 mm bis 2 mm. In einer alternativen Ausführungsform ist die Prüffläche eine Polygonfläche (die Fläche ist von einem Polygon begrenzt), insbesondere ein Rechteck oder ein Quadrat mit einer maximalen Diagonalen in einem Bereich von 0,05 mm bis 5 mm, bevorzugt in einem Bereich von 0,1 mm bis 2 mm.

Viele Magnetometer aus dem Stand der Technik weisen den Nachteil auf, dass sie nur eine vergleichsweise hohe Nachweisgrenze haben, sodass nur große Volumina eines Prüflings ein hinreichend großes Magnetfeld generieren, das sich mit diesen erfassen ließe. Eine Ortsauflösung in der erforderlichen Größenordnung, um eine Anrissbildung zu erfassen, ist dann nicht möglich, vielmehr wird über eine große Fläche des Prüflings gemittelt.

Die Ortsauflösung eines solchen Systems zum Messen der magnetischen Flussdichte an der Oberfläche des Prüflings ist darüber hinaus auch vom Abstand zwischen der Prüffläche und der Oberfläche des Prüflings abhängig. In einer Ausführungsform der Erfindung beträgt der Abstand von der Oberfläche des Prüflings zu der Prüffläche 0,05 mm bis 5 mm, vorzugsweise 0,1 mm bis 2 mm. Dabei ist der Abstand in einer Ausführungsform senkrecht zu der Oberfläche des Prüflings gemessen.

Daher umfasst das System in einer Ausführungsform einen Abstandssensor, wobei die Auswertungs- und Steuereinrichtung derart wirksam mit dem Abstandssensor verbunden ist, dass die Auswertungs- und Steuereinrichtung in dem Betrieb des Systems ein Abstandssignal von dem Abstandssensor empfängt, wobei der Abstandssensor derart eingerichtet und angeordnet ist, dass der Abstandssensor in dem Betrieb des Systems einen Abstand zwischen der Prüffläche des Flussleiters oder der Induktionskombination und der Oberfläche des Prüflings erfasst und ein den Abstand repräsentierendes Abstandssignal ausgibt. In einer Ausführungsform der Erfindung ist der Abstandssensor ein Laser-Abstandssensor.

Dabei kann das Abstandssignal auf zwei verschiedene Weisen genutzt werden. Einerseits ist es möglich, das Abstandssignal rechnerisch zur Kompensation einer mit einer Abstandsänderung einhergehende Charakteristik des Flussleiters oder der Induktionskombination zu kompensieren. In einer solchen Ausführungsform ist die Auswertungs- und Steuereinrichtung derart eingerichtet ist, dass sie in dem Betrieb des Systems für jeden Objektpunkt aus dem Prüfsignal des Objektpunkts und aus dem Abstandssignal einen Ausgabewert bestimmt.

In einer Ausführungsform der Erfindung wird zum Bestimmen des Ausgabewerts die Ortsauflösung und eine Empfindlichkeit des Systems über eine zuvor bestimmte Abstandscharakteristik mit Hilfe des Abstandssignals entfaltet.

In einer alternativen Ausführungsform wird das Abstandssignal zum Regeln des Abstands zwischen der Prüffläche und der Oberfläche des Prüflings verwendet. In einer solchen Ausführungsform muss der Aktor in der Lage sein, den Messkopf in Richtung auf die Oberfläche des Prüflings hin zu zustellen oder von dieser weg zu bewegen.

In einer Ausführungsform der Erfindung weist das System einen mechanischen Abstandshalter zum Definieren eines Abstands zwischen der Prüffläche und der Oberfläche des Prüflings auf. Dieser Abstandshalter dient dazu, in einem Betrieb des Systems den Abstand zwischen der Prüffläche und der Oberfläche des Prüflings konstant zu halten. In einer Ausführungsform der Erfindung umfasst der Abstandhalter ein auf der Oberfläche des Prüflings abrollendes Kunststoffrad.

Häufig weist ein Prüfling eine mikroskopische (Rest-)Magnetisierung auf, welche die Prüffläche durchsetzt und damit die Messung verfälscht oder stört. Daher weist das System in einer Ausführungsform der Erfindung zumindest eine Kompensationsspule und eine Kompensationssteuerung auf, wobei die Kompensationsspule derart angeordnet ist, dass ein von der Kompensationsspule in dem Betrieb des Systems generiertes, homogenes magnetisches Feld zumindest die Oberfläche des Prüflings durchsetzt, wobei die Kompensationssteuerung derart wirksam mit der Kompensationsspule verbunden ist, dass die Kompensationsspule in dem Betrieb des Systems ein Kompensationssignal von der Kompensationssteuerung empfängt, und wobei die Kompensationssteuerung derart eingerichtet ist, dass die Kompensationssteuerung in dem Betrieb des Systems das Kompensationssignal derart erzeugt, dass zumindest ein von der Kompensationsspule erzeugtes magnetisches Wechselfeld den Prüfling entmagnetisiert oder ein von der Kompensationsspule erzeugtes magnetisches Feld eine Vormagnetisierung des Prüflings kompensiert.

Die vorliegende Erfindung wird zudem durch ein Verfahren zum ortsaufgelösten Messen der magnetischen Flussdichte eines magnetischen Streufelds an der Oberfläche eines Prüflings in dem Prüfling gemäß dem darauf gerichteten unabhängigen Verfahrensanspruch gelöst. Dazu weist das Verfahren eine Mehrzahl von Schritten auf. Entweder wird eine Prüffläche eines Flussleiters ausgerichtet, sodass eine zu der Oberfläche des Prüflings senkrechte Komponente der magnetischen Flussdichte des Streufelds des Prüflings die Prüffläche durchsetzt und der magnetische Fluss des magnetischen Streufelds durch eine aktive Abschirmung und durch eine passive magnetische Abschirmung zu einem Prüfmagnetometer geleitet wird. Alternativ dazu wird eine Prüffläche einer Pick-up-Spule ausgerichtet, sodass die zu der Oberfläche des Prüflings senkrechte Komponente der magnetischen Flussdichte des Streufelds des Prüflings die Prüffläche durchsetzt und ein in der Pick-up-Spule generierter elektrischer Strom durch die aktive magnetische Abschirmung und durch die passive magnetische Abschirmung zu einer Erregerspule geleitet wird, wobei ein von der Erregerspule generiertes Prüfmagnetfeld das Prüfmagnetometer ist. Mit dem Prüfmagnetometer wird eine magnetische Flussdichte des das Prüfmagnetometer durchsetzenden Prüfmagnetfelds erfasst, wobei das Prüfmagnetometer eine Nachweisgrenze von 30 nT oder weniger aufweist und wobei das Prüfmagnetometer ein von der magnetischen Flussdichte abhängiges Prüfsignal ausgibt. Die aktive magnetische Abschirmung umfasst ein Abschirmmagnetometer, eine Abschirmspule und eine Abschirmsteuerung, wobei die Abschirmsteuerung ein Abschirmmesssignal von dem Abschirmmagnetometer empfängt, wobei die Abschirmsteuerung aus dem Abschirmmesssignal das Steuersignal derart bestimmt und an die Abschirmspule ausgibt, dass die mit dem Abschirmsteuersignal erregte Abschirmspule ein von dem Abschirmmagnetometer erfasstes magnetisches Feld kompensiert, und wobei die Abschirmspule das Abschirmsteuersignal von der Abschirmsteuerung empfängt. Ein Messkopf umfasst das Prüfmagnetometer, die passive magnetische Abschirmung, die aktive magnetische Abschirmung sowie den Flussleiter oder die Induktionskombination. Während dem Messen wird der Messkopf derart bewegt, dass eine Mehrzahl von Objektpunkten auf der Oberfläche des Prüflings ortsaufgelöst gerastert wird. Für jeden Objektpunkt der Oberfläche des Prüflings wird jeweils ein Prüfsignal aufgezeichnet.

Soweit zuvor Aspekte der Erfindung im Hinblick auf das System beschrieben wurden, so gelten diese auch für das entsprechende Verfahren zum ortsaufgelösten Messen der magnetischen Flussdichte eines magnetischen Streufelds an der Oberfläche eines Prüflings und umgekehrt. Soweit das Verfahren mit dem System gemäß dieser Erfindung ausgeführt wird, so weist dieses die entsprechenden Einrichtungen hierfür auf. Insbesondere sind Ausführungsformen des Systems zum Ausführen des Verfahrens geeignet.

Mit dem erfindungsgemäßen Verfahren und System wird die magnetische Flussdichte eines magnetischen Streufelds an der Oberfläche des Prüflings ortsaufgelöst gemessen, um Fehlstellen, wie z.B. eine Gefügeänderung, in den dem Prüfling zu identifizieren. In einer Ausführungsform weist das Verfahren daher zusätzlich den Schritt auf: Identifizieren mindestens einer lokalen Änderung in einem Bild der Oberfläche des Prüflings als eine mögliche Fehlstelle des Prüflings, wobei für jeden Objektpunkt ein Pixelwert dargestellt ist, wobei der Pixelwert das Prüfsignal oder ein daraus abgeleiteter Ausgabewert ist.

In einer Ausführungsform wird eine Änderung zwischen den Pixelwerten zweier Objektpunkte, die größer ist als ein durch den Prüfling vorgegebener Schwellenwert, als Kriterium für eine mögliche Fehlstelle des Prüflings verwendet, wobei die zwei Objektpunkte einen linearen Abstand in einem Bereich von 0,05 bis 2 mm aufweisen und wobei der Schwellenwert größer als die Nachweisgrenze des Prüfmagnetometers ist.

Weitere Vorteile, Merkmale und Anwendungsmöglichkeiten der vorliegenden Erfindung werden anhand der folgenden Beschreibung von Ausführungsformen und der dazugehörigen Figuren deutlich. In den Figuren sind gleiche Elemente mit identischen Bezugszeichen bezeichnet.
- Figur 1: ist eine schematische Querschnittsansicht einer ersten Ausführungsform eines erfindungsgemäßen Systems zum ortsaufgelösten Messen der magnetischen Flussdichte eines magnetischen Streufelds an der Oberfläche eines Prüflings.
- Figur 2: ist eine schematische isometrische Ansicht einer weiteren Ausführungsform eines erfindungsgemäßen Systems.
- Figur 3: ist eine schematische Querschnittsansicht des Systems aus Figur 2.
- Figur 4: ist eine schematische Darstellung einer erfindungsgemäßen aktiven Abschirmung.
- Figur 5: ist eine schematische Darstellung einer weiteren Ausführungsform des erfindungsmäßen Systems.
- Figur 6: ist eine schematische Erläuterung zum räumlichen Auflösungsvermögen des erfindungsgemäßen Systems.

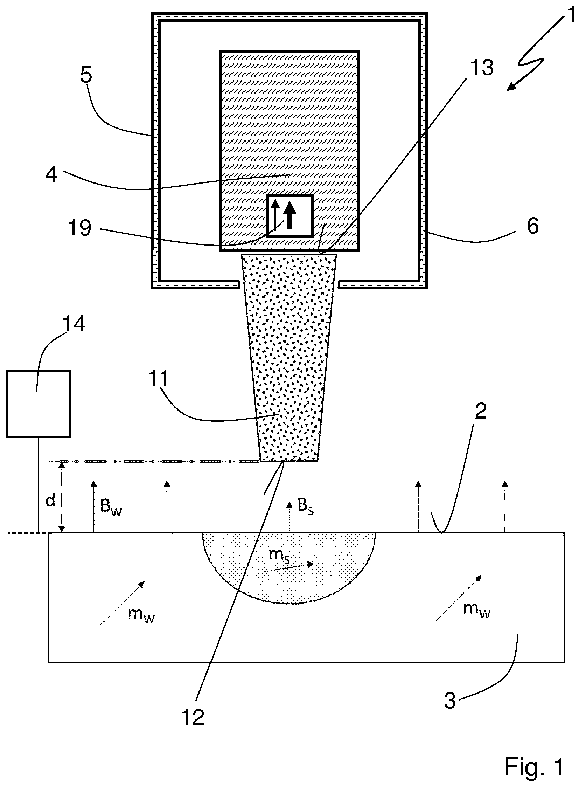

Figur 1 ist eine schematische Darstellung einer Ausführungsform eines erfindungsgemäßen Systems 1 zum ortsaufgelösten Messen der magnetischen Flussdichte eines magnetischen Streufelds an der Oberfläche 2 eines Prüflings 3. Diese ortsaufgelöste Messung dient dazu, lokale mechanische Spannungskonzentrationen in dem Prüfling 3 und damit Ausgangsstellen für ein Versagen des Prüflings 3 unter (zyklischer) mechanischer Beanspruchung zu identifizieren.

In allen dargestellten Ausführungsform umfasst das System 1 jeweils ein oder mehrere optisch gepumpte Magnetometer 4, welche in der Lage sind, Änderungen in einem Magnetfeld von weniger als 50 pT zu erfassen. In allen Ausführungsformen ist das Prüfmagnetometer 4 ein optisch gepumptes Nullfeld-Magnetometer (OPM). In einer Gaszelle 19, dem eigentlichen sensitiven Bereich des Magnetometers 4 werden gasförmige Rubidium-Atome als Magnetfeldsonden eingesetzt. Zu diesem Zweck wird der quantenmechanische Zustand der Rubidium-Atome mit Laserlicht präpariert ("gepumpt") und die Wirkung des zu messenden Magnetfelds auf diesen Zustand der verwendeten Atome wird mit Laserlicht und einem laserspektroskopischen Verfahren ausgelesen. Die Lamorfrequenz der in dem Magnetfeld präzidierenden Spins in der Gaszelle 19 ist ein direktes Maß für die Feldstärke des aus dem Flussleiter oder dem Helmholzspulenpaar austretenden und auf den sensitiven Bereich 19 einwirkenden magnetischen Felds. Die Endfläche 13 des Flussleiters oder die Flächen der Helmholzspulenpaare ist an die Gaszelle 19 des Magnetometers 4 angepasst.

Um diese geringe Ansprechschwelle aber auch die geringe Nachweisgrenze nutzen zu können, ist es erforderlich, das Magnetometer 4 in besonderer Weise abzuschirmen.

Bereits das bei terrestrischen Messungen immer vorhandene Erdmagnetfeld liegt mit etwa 40 µT weit über der Nachweisgrenze des verwendeten Magnetometers. Daher weist das System 1 eine doppelte magnetische Abschirmung auf, die sich aus einer passiven magnetischen Abschirmung 5 und einer aktiven magnetischen Abschirmung 6 zusammensetzt. Bei der passiven magnetischen Abschirmung 5 handelt es sich um ein Mu-Metallgehäuse, welches das Magnetometer 6 möglichst unterbrechungsfrei umgibt.

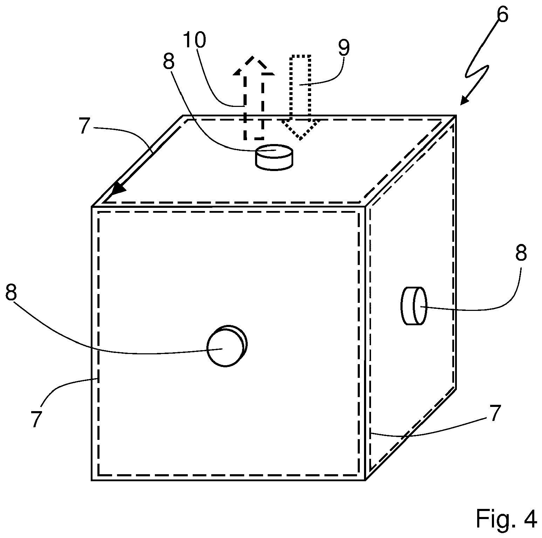

Die aktive magnetische Abschirmung 6 ist in Figur 4 schematisch dargestellt. Sechs auf den gedachten Seitenflächen eines Würfels angeordnete Kompensationsspulen 7 umgeben das Magnetometer im Inneren dieses schematisch in Figur 4 gezeigten Würfels. Jeder Spule 7 ist ein Vektormagnetometer 8 zugeordnet, welches jeweils die orthogonal zu der von der jeweiligen Spule 7 aufgespannten Fläche stehende Komponente 9 des Störfelds und damit des magnetischen Umgebungsrauschens misst. Anhand der Messung dieses Störfelds erzeugt nun die jeweilige Spule eines Paars aus Spule 7 und Magnetometer 8 einen Strom, welcher ein magnetisches Feld 10 generiert, das dem Störfeld entgegenwirkt. Sind Störfeld 9 und entgegenwirkendes Feld 10 gleich groß, so durchdringt das Störfeld die Fläche nicht mehr. Da das gleiche Regelprinzip für alle Spulen 7 auf allen sechs Flächen des Würfels angewandt wird, wird das Magnetfeld innerhalb des Würfels auf 0 geregelt.

Die Magnetisierung des Prüflings 3 mw erzeugt an der Oberfläche 2 des Prüflings 3 ein magnetisches Feld Bw. Bei einem Prüfling mit einer hohen magnetischen Permeabilität, d.h. µᵣ >> 1, beispielsweise bei einem ferromagnetischen Material des Prüflings 3, ist das magnetische Feld Bw aufgrund der magnetischen Brechung an der Oberfläche 2 im Wesentlichen senkrecht zu dieser Oberfläche 2.

Eine lokale mechanische Spannung in dem Werkstoff des Prüflings 3 geht in einem ferromagnetischen Werkstoff mit magnetischen Momenten einher. Figur 1 zeigt beispielhaft eine solche Störstelle bzw. die damit einhergehende Änderung der Magnetisierung ms in dem Prüfling 3. Aufgrund der Änderung der Magnetisierung in der Probe im Bereich mit veränderter mechanischer Spannung gegenüber den unveränderten Bereichen des Prüflings 3 ändert sich auch das magnetische Feld des Prüflings in diesem Bereich. Dieser Bereich ist mit dem magnetischen Feld Bs in Figur 1 bezeichnet. Wenn es möglich ist, die auf diese Weise entstehenden lokalen Änderungen des magnetischen Felds B von Bw zu Bs an der Oberfläche 2 des Prüflings 3 ortsaufgelöst zu erfassen, so können Gefügeveränderungen im Werkstoff des Prüflings 3 frühzeitig, d.h. noch vor der Ausbildung von Anrissen, erkannt werden und der Prüfling identifiziert oder aussortiert werden.

Das lokale magnetische Feld Bw, Bs wird von der Oberfläche des Prüflings 3 zu dem Magnetometer 4 geleitet. In der Ausführungsform aus Figur 1 übernimmt diese Aufgabe ein magnetischer Flussleiter 11. Die der Oberfläche 2 des Prüflings 3 zugewandte Endfläche bildet die Prüffläche 12 des Flussleiters 11. Der Flussleiter 11 aus einem weichmagnetischen Werkstoff wird mit seiner Prüffläche 12 in einem Abstand d zur Oberfläche 2 des Prüflings 3 geführt. Die Prüffläche 12 ist dabei parallel zur Oberfläche 2 des Prüflings 3 ausgerichtet. Daher leitet der Flussleiter 11 die magnetische Flussdichte, die mit den zur Oberfläche 2 senkrechten Komponenten des Magnetfelds Bw, Bs verbunden ist, an das Magnetometer 4 weiter. Dieser magnetische Fluss durchsetzt an der dem Magnetometer 4 zugewandten Seite die Endfläche 13 des Flussleiters 11 und damit den sensitiven Teil des Magnetometers 4.

Die charakteristischen Dimensionen der Prüffläche 12 sowie deren Abstand d von der Oberfläche 2 des Prüflings 3 bestimmen die Ortsauflösung parallel zur Oberfläche 2, mit der Änderungen der magnetischen Feldstärke Bw, Bs an der Oberfläche 2 des Prüflings 3 gemessen werden können.

Eine Prüffläche 12 mit kleinen charakteristischen Dimensionen erhöht die Ortsauflösung, senkt aber die Empfindlichkeit der Messung. In dem gezeigten Beispiel ist die Prüffläche 12 kreisförmig, sodass ihre charakteristische Dimension der Durchmesser dieser Kreisfläche ist. In der gezeigten Ausführungsform beträgt der Durchmesser der Kreisfläche 0,5 mm.

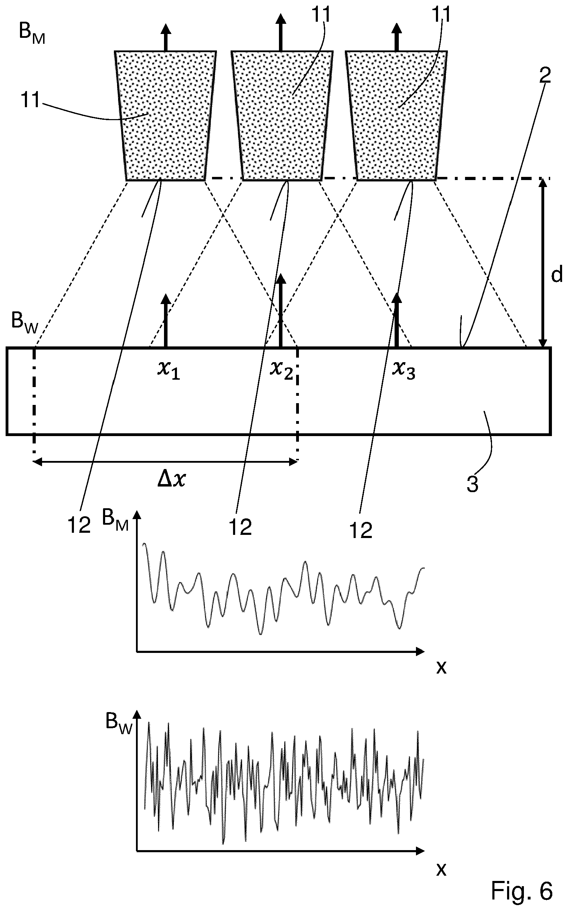

Darüber hinaus weist das System einen Laserabstandssensor 14 auf, der während der Magnetfeldmessung den Abstand d zwischen der Prüffläche 12 und der Oberfläche 2 des Prüflings 3 erfasst. Der gemessene Abstand d wird dazu verwendet, durch Entfaltung die wahre Feldverteilung Bw, Bs aus dem vom Magnetometer ausgegebenen Signal zu rekonstruieren. Ein Beispiel dafür ist in Figur 6 gezeigt. Die linke Prinzipskizze verdeutlicht drei zeitlich nacheinander angefahrene Messpositionen des Flussleiters 11 bzw. dessen Prüffläche 12. Es ist zu erkennen, dass sich diejenigen Bereiche auf der Oberfläche 2 des Prüflings 3 befinden, die an jeder Messposition des Flussleiters 11 erfasst werden, einander überlappen. Die in dem Magnetometer 4 gemessenen Feldstärke B_{M} (*x̅ᵢ*) kann als ein tiefpassgefiltertes Signal mit der Übertragungsfunktion A(d, *x̅ᵢ*-*x̅ⱼ*) der eigentlichen Messgröße Bw (*x̅ᵢ*) beschrieben werden. Durch Entfaltung wird unter Nutzung des Abstandes d aus dem Abstandssensor aus dem Messwert B_{M} (*x̅ᵢ*) die Feldstärke Bw (*x̅ᵢ*) an der Oberfläche 2 des Prüflings 3 berechnet. Rechts unten in Figur 6 ist beispielhaft ein Verlauf einer Feldverteilung Bw an der Oberfläche 2 des Prüflings 3 an einer Vielzahl von Messpunkten *x̅ᵢ* gezeigt. Das entsprechende, tiefpassgefilterte Magnetometersignal B_{M} ist auf der rechten Seite der Figur 6 oben dargestellt. Durch Entfaltung kann die Feldverteilung Bw an der Oberfläche 2 des Prüflings 3 aus dem Magnetometersignal B_{M} berechnet werden.

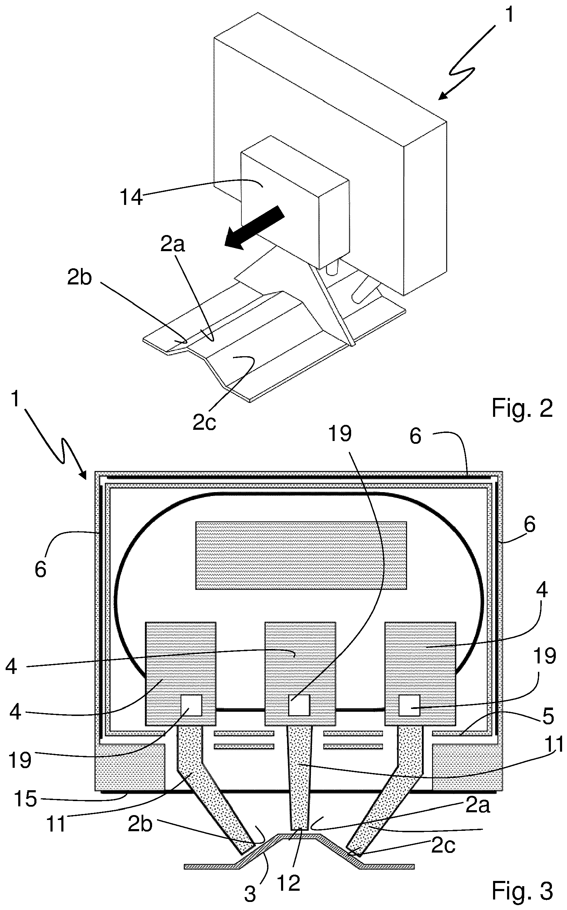

Figur 2 zeigt eine isometrische, schematische Darstellung eines Systems 1 in einer Ausführungsform mit drei Magnetometern. Diese dienen dazu, drei dachförmig angeordnete, mit drei dachförmig durch Tiefziehen aus einem ferromagnetischen Blech geformte Abschnitte 2a, 2b, 2c der Oberfläche 2 eines Prüflings 3 zu vermessen. Figur 3 zeigt schematisch einen Querschnitt durch einen Teil des Systems. Deutlich sind die drei Flussleiter 11 und die diesen jeweils zugeordneten Magnetometer 4 erkennbar. In der gezeigten Ausführungsform dient der Laserabstandssensor 14 dazu, nicht nur den Abstand zwischen der Prüffläche 12 des Flussleiters 11, der auf den mittigen, horizontal verlaufenden Oberflächenabschnitt 2a des Prüflings 3 blickt, und diesem Oberflächenabschnitt 2a sondern auch die seitliche Position der Kontur des Prüflings 3 relativ zu den Prüfflächen der beiden weiteren Flussleiter 11 zu bestimmen.

Wie zuvor besteht das Gehäuse der passiven magnetischen Abschirmung 5 aus einer Mehrzahl von Lagen aus Mu-Metall mit zwischen diesen Lagen integriert angeordneten Abschirmspulen 7 der aktiven magnetischen Abschirmung.

Zudem ist eine Gegenspule 15 zwischen der passiven Abschirmung 5 und dem Prüfling 3 angeordnet. Diese dient dazu, eine mittlere Magnetisierung der Probe, beispielsweise eine entsprechende Vormagnetisierung, großflächig im Verhältnis zur Ortsauflösung des Sensors zu kompensieren. Auf diese Weise können lokale Änderungen des Magnetfelds Bw, so wie sie beispielsweise durch Spannungskonzentrationen in dem Werkstoff des Prüflings 3 auftreten, empfindlicher gemessen werden. Die Kompensationsspule weist einen Spulendurchmesser auf, der deutlich größer ist als der Abstand d zwischen dem Prüfling und den jeweiligen Flussleitern 11. Auf diese Weise wird im Bereich der Flussleiter 11 des Systems 1 ein homogenes magnetisches Feld senkrecht zur Probenoberfläche erzeugt. Der Strom durch die Kompensationsspule 15 kann aus den Messwerten der Prüfmagnetometer 4 berechnet werden, zum Beispiel indem man ihren Mittelwert auf 0 kompensiert.

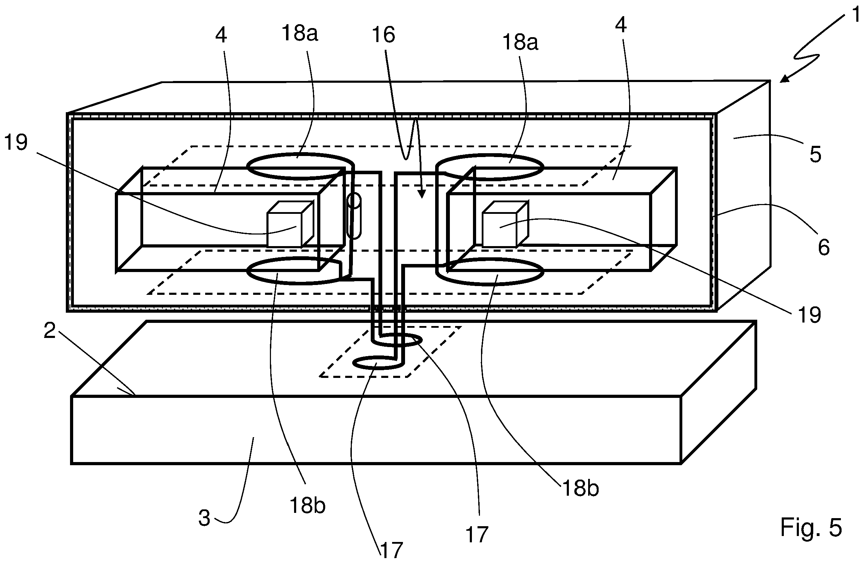

Figur 5 zeigt eine alternative Ausführungsform des Systems 1, bei dem der magnetische Flussleiter 11 der Varianten aus den Figuren 1 bis 3 durch eine Induktionskombination mit einer Pick-up-Spule 17 und einem Helmholzspulenpaar 18a, 18b als Erregerspulen ersetzt wurde. Die Pick-up-Spule 17 nimmt die Änderung des Magnetfelds Bw an der Probe über Induktion auf und setzt diese mittels der Erregerspulen 18a, 18b auf die empfindliche Achse des OPM-Magnetometers 4 um. Das System 1 aus Figur 5 verfügt über zwei Magnetometer 4, die jeweils mit einer Induktionskombination 16 versehen sind.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

### Bezugszeichenliste

- 1: System
- 2: Oberfläche
- 2a, 2b, 2c: Flächenabschnitt der Oberfläche 2
- 3: Prüfling
- 4: OPM-Magnetometer
- 5: passive magnetische Abschirmung
- 6: aktive magnetische Abschirmung
- 7: Abschirmspule
- 8: Abschirmmagnetometer
- 9: Störfeld
- 10: Gegenfeld
- 11: Flussleiter
- 12: Prüffläche
- 13: magnetometerseitige Endfläche des Flussleiters
- 14: Laserabstandssensor
- 15: Kompensationsspule
- 16: Induktionskombination
- 17: Pick-up-Spule
- 18a, 18b: Helmholzspulenpaar
- 19: Gaszelle des Prüfmagnetometers

- Bw, Bs: magnetische Feldstärke
- d: Abstand
- A(d, *x̅ᵢ*-*x̅ⱼ*): Übertragungsfunktion
- Bw (*x̅ᵢ*): Messgröße
- *x̅ᵢ*: Messpunkte
- B_{M} (*x̅ᵢ*): Magnetometersignal

## Patentansprüche

1. System (1) zum ortsaufgelösten Messen der magnetischen Flussdichte eines magnetischen Streufelds an der Oberfläche (2) eines Prüflings (3) mit
einem Prüfmagnetometer (4),
wobei das Prüfmagnetometer (4) eine Nachweisgrenze von 30 nT oder weniger aufweist, und
wobei das Prüfmagnetometer (4) in einem Betrieb des Systems (1) ein von einem Prüfmagnetfeld abhängiges Prüfsignal (B_{M} (*x̅ᵢ*)) ausgibt,
einer passiven magnetischen Abschirmung (5),
wobei das Prüfmagnetometer (4) innerhalb der passiven magnetischen Abschirmung (5) angeordnet ist,
einer aktiven magnetischen Abschirmung (6),
wobei das Prüfmagnetometer (4) innerhalb der aktiven magnetischen Abschirmung (6) angeordnet ist,
wobei die aktive magnetische Abschirmung (6) ein Abschirmmagnetometer (8), eine Abschirmspule (7) und eine Abschirmsteuerung umfasst, wobei das Abschirmmagnetometer (8) derart wirksam mit der Abschirmsteuerung verbunden ist, dass die Abschirmsteuerung in dem Betrieb des Systems (1) ein Abschirmmesssignal von dem Abschirmmagnetometer (8) empfängt und die Abschirmsteuerung derart wirksam mit der Abschirmspule (7) verbunden ist, dass die Abschirmspule (7) in dem Betrieb des Systems (1) ein Abschirmsteuersignal von der Abschirmsteuerung empfängt,
wobei die Abschirmsteuerung derart eingerichtet ist, dass sie in dem Betrieb des Systems (1) aus dem Abschirmmesssignal das Abschirmsteuersignal derart bestimmt und an die Abschirmspule (7) ausgibt, dass die mit dem Abschirmsteuersignal erregte Abschirmspule (7) ein von dem Abschirmmagnetometer (8) erfasstes magnetisches Feld kompensiert,
entweder einem Flussleiter (11) mit einer Prüffläche,
wobei der Flussleiter (11) derart ausgestaltet und angeordnet ist, dass in dem Betrieb des Systems (1) der Flussleiter (11) einen magnetischen Fluss des magnetischen Streufelds von der Oberfläche (2) des Prüflings (3), das die Prüffläche (12) durchsetzt, durch die aktive magnetische Abschirmung (6) und durch die passive magnetische Abschirmung (5) zu dem Prüfmagnetometer (4) leitet, sodass das von dem Streufeld abhängige Prüfmagnetfeld das Prüfmagnetometer (4) durchsetzt,
oder einer Induktionskombination (16), die eine Pick-up-Spule (17) mit einer Prüffläche (12) und eine Erregerspule (18a, 18b) umfasst,
wobei die Induktionskombination (16) derart ausgestaltet und angeordnet ist, dass der magnetische Fluss des magnetischen Streufelds von der Oberfläche (2) des Prüflings (3) die Prüffläche (12) durchsetzt und ein generierter elektrischer Strom über die Erregerspule (18a, 18b) in dem Prüfmagnetometer (4) das von dem Streufeld abhängige Prüfmagnetfeld erzeugt,
wobei der Flussleiter (11) oder die Induktionskombination (16) derart ausgestaltet ist, dass sie eine zu der Oberfläche (2) des Prüflings (3) senkrechte Komponente der magnetischen Flussdichte des Streufelds erfasst,
einem Messkopf,
wobei der Messkopf das Prüfmagnetometer (4), die passive magnetische Abschirmung (5), die aktive magnetische Abschirmung (6) sowie den Flussleiter (11) oder die Induktionskombination (16) umfasst,
einem Aktor,
wobei der Aktor derart ausgestaltet und angeordnet ist, dass er in dem Betrieb des Systems (1) den Messkopf automatisiert bewegt, um eine Mehrzahl von Objektpunkten auf der Oberfläche (2) des Prüflings (3) ortsaufgelöst zu rastern, und
einer Auswertungs- und Steuereinrichtung,
wobei die Auswertungs- und Steuereinrichtung derart wirksam mit dem Aktor verbunden ist, dass der Aktor in dem Betrieb des Systems (1) ein Aktorsteuersignal von der Auswertungs- und Steuereinrichtung empfängt,
wobei die Auswertungs- und Steuereinrichtung derart wirksam mit dem Prüfmagnetometer (4) verbunden ist, dass die Auswertungs- und Steuereinrichtung in dem Betrieb des Systems (1) das Prüfsignal (B_{M} (*x̅ᵢ*)) von dem Prüfmagnetometer (4) empfängt, und
wobei die Auswertungs- und Steuereinrichtung derart eingerichtet ist, dass sie in dem Betrieb des Systems jeweils ein Prüfsignal (B_{M} (*x̅ᵢ*)) für jeden Objektpunkt aufzeichnet.

2. System (1) nach dem vorhergehenden Anspruch, wobei die Prüffläche (12) des Flussleiters (11) oder der Induktionskombination (16) eine ebene Fläche ist, wobei die Prüffläche (12) derart angeordnet ist, dass sie parallel zu der zu erfassenden Oberfläche (2) des Prüflings (3) ausrichtbar ist.

3. System (1) nach einem der vorhergehenden Ansprüche, wobei die Prüffläche (12) eine Kreisfläche mit einem Durchmesser in einem Bereich von 0,05 mm bis 5 mm ist oder die Prüffläche eine Polygonfläche mit einer maximalen Diagonale in einem Bereich von 0,05 mm bis 5 mm ist.

4. System (1) nach einem der vorhergehenden Ansprüche, wobei die aktive magnetische Abschirmung (6) drei Paare mit jeweils einem Abschirmmagnetometer (8) und einer Abschirmspule (9) aufweist,
wobei jeweils ein Paar auf einer Fläche eines Polyeders angeordnet ist,
wobei die Abschirmsteuerung derart eingerichtet ist, dass sie in dem Betrieb des Systems (1) aus den Abschirmmesssignalen Abschirmsteuersignale derart bestimmt und an die Abschirmspulen (9) ausgibt, dass die mit dem Abschirmsteuersignal erregte Abschirmspule (9) ein von dem Abschirmmagnetometer (8) erfasstes magnetisches Feld, welches die jeweilige Fläche des Polyeders durchsetzt, kompensiert.

5. System (1) nach einem der vorhergehenden Ansprüche, wobei das System (1) einen Abstandssensor (14) aufweist,
wobei die Auswertungs- und Steuereinrichtung derart wirksam mit dem Abstandssensor (14) verbunden ist, dass die Auswertungs- und Steuereinrichtung in dem Betrieb des Systems (1) ein Abstandssignal (d) von dem Abstandssensor (14) empfängt,
wobei der Abstandssensor (14) derart eingerichtet und angeordnet ist, dass der Abstandssensor (14) in dem Betrieb des Systems einen Abstand zwischen der Prüffläche (12) des Flussleiters (11) oder der Induktionskombination (16) und der Oberfläche (2) des Prüflings (3) erfasst und das den Abstand (d) repräsentierende Abstandsignal ausgibt, und
wobei die Auswertungs- und Steuereinrichtung derart eingerichtet ist, dass sie in dem Betrieb des Systems (1) für jeden Objektpunkt aus dem Prüfsignal (B_{M} (*x̅ᵢ*)) des Objektpunkts und aus dem Abstandssignal einen Ausgabewert bestimmt.

6. System (1) nach einem der vorhergehenden Ansprüche, wobei das System (1) einen mechanischen Abstandshalter zum Definieren eines Abstands (d) zwischen der Prüffläche (12) und der Oberfläche (2) des Prüflings (3) aufweist.

7. System (1) nach einem der vorhergehenden Ansprüche, wobei das System (1) zumindest eine Kompensationsspule (15) und eine Kompensationssteuerung aufweist,
wobei die Kompensationsspule (15) derart angeordnet ist, dass ein von der Kompensationsspule (15) in dem Betrieb des Systems (1) generiertes, homogenes magnetisches Feld zumindest die Oberfläche (2) des Prüflings (3) durchsetzt,
wobei die Kompensationssteuerung derart wirksam mit der Kompensationsspule (15) verbunden ist, dass die Kompensationsspule (15) in dem Betrieb des Systems ein Kompensationssignal von der Kompensationssteuerung empfängt, und
wobei die Kompensationssteuerung derart eingerichtet ist, dass die Kompensationssteuerung in dem Betrieb des Systems das Kompensationssignal derart erzeugt, dass zumindest ein von der Kompensationsspule (15) erzeugtes magnetisches Wechselfeld den Prüfling (3) entmagnetisiert oder ein von der Kompensationsspule (15) erzeugtes magnetisches Feld eine Vormagnetisierung des Prüflings (3) kompensiert.

8. Verfahren zum ortsaufgelösten Messen der magnetischen Flussdichte eines magnetischen Streufelds an der Oberfläche eines Prüflings mit den Schritten
entweder
Ausrichten einer Prüffläche eines Flussleiters, sodass die zu der Oberfläche (2) des Prüflings (3) senkrechte Komponente der magnetischen Flussdichte des Streufelds des Prüflings (3) die Prüffläche (12) durchsetzt, und
Leiten des magnetischen Flusses des magnetischen Streufelds durch eine aktive magnetische Abschirmung (6) und durch eine passive magnetische Abschirmung (5) zu einem Prüfmagnetometer (4), sodass ein von dem Streufeld abhängiges Prüfmagnetfeld das Prüfmagnetometer (4) durchsetzt,
oder
Ausrichten einer Prüffläche einer Pick-up-Spule, sodass die zu der Oberfläche (2) des Prüflings (3) senkrechte magnetische Flussdichte des Streufelds des Prüflings (3) die Prüffläche (12) durchsetzt, und
Leiten eines in der Pick-up-Spule generierten elektrischen Stroms durch die aktive magnetische Abschirmung (6) und durch die passive magnetische Abschirmung (5) zu einer Erregerspule (18a, 18b), wobei das von der Erregerspule (18a, 18b) generierte, vom dem Streufeld abhängige Prüfmagnetfeld das Prüfmagnetometer (4) durchsetzt,
Erfassen der magnetischen Flussdichte des das Prüfmagnetometer (4) durchsetzenden Prüfmagnetfelds mit dem Prüfmagnetometer (4),
wobei das Prüfmagnetometer (4) eine Nachweisgrenze von 30 nT oder weniger aufweist, und
wobei das Prüfmagnetometer (4) ein von der magnetischen Flussdichte abhängiges Prüfsignal (B_{M} (*x̅ᵢ*)) ausgibt,
wobei die aktive magnetische Abschirmung (6) ein Abschirmmagnetometer (8), eine Abschirmspule (7) und eine Abschirmsteuerung umfasst,
wobei die Abschirmsteuerung ein Abschirmmesssignal von dem Abschirmmagnetometer (8) empfängt,
wobei die Abschirmsteuerung aus dem Abschirmmesssignal das Abschirmsteuersignal derart bestimmt und an die Abschirmspule (7) ausgibt, dass die mit dem Abschirmsteuersignal erregte Abschirmspule (7) ein von dem Abschirmmagnetometer (8) erfasstes magnetisches Feld kompensiert, und
wobei die Abschirmspule (7) das Abschirmsteuersignal von der Abschirmsteuerung empfängt,
Bewegen eines Messkopfes, sodass eine Mehrzahl von Objektpunkten auf der Oberfläche (2) des Prüflings (3) ortsaufgelöst gerastert wird,
wobei der Messkopf das Prüfmagnetometer (4), die passive magnetische Abschirmung (5), die aktive magnetische Abschirmung (6) sowie den Flussleiter (11) oder die Induktionskombination (16) umfasst, und
Aufzeichnen jeweils eines Prüfsignals für jeden Objektpunkt der Oberfläche (2) des Prüflings (3).

9. Verfahren nach Anspruch 8, wobei die Prüffläche (12) eine ebene Fläche ist.

10. Verfahren nach Anspruch 8 oder 9, wobei die Prüffläche (12) parallel zu der Oberfläche (2) des Prüflings (3) ist.

11. Verfahren nach einem der Ansprüche 8 bis 10, wobei die Prüffläche (12) einen Abstand (d) von der Oberfläche (2) des Prüflings (3) in einem Bereich von 0,05 mm bis 5 mm aufweist.

12. Verfahren nach einem der Ansprüche 8 bis 11, wobei das Verfahren weiterhin die Schritte aufweist:
Erfassen des Abstands (d) zwischen der Prüffläche (12) und der Oberfläche (2) des Prüflings (3),
Bestimmen eines Ausgabewerts für jeden Objektpunkt aus dem Prüfsignal des Objektpunkts und dem Abstand (d) und
Erzeugen eines Bilds der Oberfläche (2) mit jeweils einem Ausgabewert für jeden Objektpunkt.

13. Verfahren nach einem der Ansprüche 8 bis 12, wobei das Verfahren zusätzlich den Schritt aufweist:
Identifizieren mindestens einer lokalen Änderung in einem Bild der Oberfläche (2) des Prüflings (3) als eine mögliche Fehlstelle des Prüflings (3), wobei für jeden Objektpunkt ein Pixelwert dargestellt ist, wobei der Pixelwert das Prüfsignal oder ein daraus abgeleiteter Ausgabewert ist.

14. Verfahren nach dem vorhergehenden Anspruch, wobei eine Änderung zwischen den Pixelwerten zweier Objektpunkte, die größer ist als ein durch den Prüfling (3) vorgegebener Schwellenwert, als Kriterium für eine mögliche Fehlstelle des Prüflings (2) verwendet wird, wobei die zwei Objektpunkte einen linearen Abstand in einem Bereich von 0,05 bis 2 mm aufweisen und wobei der Schwellenwert größer als die Nachweisgrenze ist.
